Europäisches Patentamt

European Patent Office

Office européen des brevets

Veröffentlichungsnummer: **0 440 928 A2**

## EUROPÄISCHE PATENTANMELDUNG

Anmeldenummer: 90123919.4

Anmeldetag: **12.12.90**

Int. Cl.5: **H05K 3/00**

Priorität: **05.02.90 DE 4003344**

Veröffentlichungstag der Anmeldung:
**14.08.91 Patentblatt 91/33**

Benannte Vertragsstaaten:
**AT BE CH DE DK ES FR GB GR IT LI LU NL SE**

Anmelder: **Firma Carl Freudenberg**
**Höhnerweg 2-4**
**W-6940 Weinheim/Bergstrasse(DE)**

Erfinder: **Kober, Horst**
**Berggewannn 5**
**W-6940 Weinheim(DE)**

Verfahren zur Herstellung einer starre und flexible Bereiche aufweisenden Leiterplatte.

Ein Verfahren zur Herstellung einer starre und flexible Bereiche aufweisenden Leiterplatte durch Verpressen von starren und flexiblen Einzellagen und Entfernen der starren Außenlage in den flexibel gewünschten Bereichen durch vorgebildete Sollbruchstellen besteht darin, daß man nach dem Ausbilden der Sollbruchstellen auf der starren, mit einer Kupferschicht kaschierten Einzellage innerhalb des flexibel zu gestaltenden Bereichs ein die Klebefähigkeit des verwendeten Klebers verhinderndes, bis zu 200 ° C temperaturbeständiges Trennmittel auf die der Kupferschicht abgewandte Seite aufträgt, daß man anschließend eine mit Kleber beschichtete Isolationsfolie auf die starre Einzellage nur im flexibel zu gestaltenden Bereich aufklebt, wobei die Isolationsfolie allseitig um 3 bis 5 mm die Abmessungen des flexiblen Bereichs überragt, daß man dann über die Isolationsfolie einschließlich der starren Bereiche der Einzellage eine durchgehende Kupferfolie mittels einer klebenden Schicht klebt, wobei diese Schicht auf ihrer gesamten Fläche die Isolationsfolie um mindestens 1 μm in der Höhe überragt, daß man den Verbund unter Druck und Hitze zu einem Laminat verpreßt, die Klebeverbindungen aushärten läßt und nach der Leiterbildherstellung und der Konturbearbeitung zuletzt im flexiblen Bereich die Einzellage mit der Kupferbeschichtung entlang den Sollbruchstellen entfernt.

EP 0 440 928 A2

## VERFAHREN ZUR HERSTELLUNG EINER STARRE UND FLEXIBLE BEREICHE AUFWEISENDEN LEITERPLATTE

Die Erfindung betrifft ein Verfahren zur Herstellung einer starre und flexible Bereiche aufweisenden Leiterplatte gemäß dem Oberbegriff des Anspruchs 1.

Ein solches Verfahren wird in der DE-PS 26 57 212 beschrieben. Die flexiblen Einzellagen überdecken dabei die gesamte Leiterplatte, obwohl sie nur im flexiblen Teil benötigt werden. Ferner sind die für die flexiblen Lagen verwendeten Kunststoffolien hygroskopisch, so daß beim Löten der Schaltung durch das Verdampfen der absorbierten Feuchtigkeit Delaminationen zwischen flexibler und starrer Lage auftreten können.

Der zwischen der starren und flexiblen Einzellage benötigte Kleber muß nichtfließend sein, d.h. er ist auch während des Verpressens so zäh, daß er nicht in die flexiblen Bereiche fließen und dort versehentlich den flexiblen Teil mit der starren Außenlage verkleben kann. Solche Kleber benötigen zum Verpressen den Einsatz eines in der Technik bekannten Druckausgleichspolsters, um trotz ihrer hohen Viskosität eine homogene Verklebung von flexibler und starrer Einzellage zu erzielen. Dieses Polster bewirkt jedoch, wenn Leiterbahnen auch auf der Innenseite der starren Einzellage vorhanden sind, ein Durchdrücken dieser Leiterbahnen in die flexible Einzellage, was zu Reliefbildung auf der Kupferfolie führt. Die ätztechnische Herstellung der Leiterbahnen auf dieser Kupferfolie wird somit erschwert.

In der deutschen Patentschrift 36 24 718 wird beschrieben, wie eine mehrlagige starr-flexible Leiterplatte mit flexiblen Kunststoffolien nur im flexiblen Teil hergestellt wird. Aber dieses Verfahren benötigt die Herstellung starr/ flexibler Vorlaminate und ist auf mehrlagige Leiterplatten beschränkt.

Aufgabe der Erfindung ist es, ein Verfahren zur Herstellung einer starre und flexible Bereiche aufweisenden Leiterplatte anzugeben, wobei flexible Isolationsfolien nur in den flexiblen Bereichen eingesetzt werden, jedoch ohne Zuhilfenahme von Vorlaminaten, und wobei auf Druckausgleichspolster verzichtet werden kann.

Diese Aufgabe wird durch die Art und Reihenfolge der folgenden Verfahrensschritte gelöst: In einer starren Einzellage werden zunächst mittels Ausbildung von Sollbruchstellen, z.B. durch Nuten oder Stanzen, entlang der Trennungslinie zwischen starrem und flexiblem Teil der Leiterplatte hergestellt. Diese Einzellage besteht zweckmäßig aus glasfaserverstärktem Epoxidharz und kann auch bereits eine ein- oder zweiseitige Kupferkaschierung aufweisen.

Dann wird auf der starren Einzellage eine bis zu 200°C temperaturbeständige Trennschicht durchgehend in dem flexiblen Bereich aufgebracht. Diese Trennschicht darf mit dem später zu verwendenden Kleber keine Haftung bilden. Sie kann in flüssiger Form aufgetragen werden, wie dies z.B. mit Polytetrafluorethylen-Spray oder siebdruckfähigem Polyethylen leicht möglich ist. Alternativ kann eine Trennfolie aus PTFE verwendet werden.

Flexible, kleberbeschichtete Isolationsfolien-Stücke, wie sie in der Leiterplattentechnik z.B. in Form von kleberbeschichteten Polyimidfolien-Stükken gebräuchlich sind, mit 3 bis 5 mm größeren Abmessungen als die flexiblen Bereiche werden mit der Kleberseite zur starren Einzellage hin auf diese im flexiblen Bereich angeheftet. Die angegebene Größe der Verklebungsfläche zwischen der Isolationsfolie und den starren Bereichen genügt, um die Verklebung der Isolationsfolie mit dem starren Träger genügend sicher auszugestalten.

Über die Isolationsfolie einschließlich der starren Bereiche der Einzellage legt man dann eine durchgehende Klebefolie oder ein Prepreg aus Glasgewebe, getränkt mit einem nicht ausgehärteten Harz, vorzugsweise Epoxidharz. Abschließend wird eine ebenfalls durchgehende Kupferfolie aufgelegt. Die Kleber- bzw. Prepreg- Dicke wird mindestens 1 μm größer als die Gesamtdicke der Isolationsfolie einschließlich der Kleberschicht gewählt.

Der Verbund wird dann unter Druck und einer Temperatur, die ausreicht, die Kleberschichten aktiv werden zu lassen, zu einem Laminat verpreßt, wobei die Klebefolie bzw. das Prepreg am Anfang des Preßzyklus niedrigviskos wird und die Isolationsfolie somit luftfrei in diese Klebeschicht sich einbettet. Im weiteren Verlauf härtet die Kleberschicht aus und verklebt alle Materialschichten miteinander. Der kurzzeitige Klebefluß bewirkt gleichzeitig einen Druckausgleich, so daß auf zusätzliche Druckausgleichspolster beim Pressen verzichtet werden kann und man ein planes Laminat mit glatten Kupferoberflächen erhält.

Dieses Laminat kann dann mit bekannten Durchkontaktierungs- und Strukturierverfahren, wie man sie bei starren Leiterplatten oder Mehrlagenschaltungen einsetzt, weiter bearbeitet werden.

Nach der Konturbearbeitung kann im flexiblen Bereich der starr-flexiblen Leiterplatte das Teilstück der starren Einzellage in diesem Bereich entlang der Sollbruchstellen mühelos entfernt werden.

Eine vorteilhafte Weiterentwicklung der Erfindung ergibt, wenn man die kleberbeschichtete Isolationsfolie durch eine textile Verstärkung, wie z.B. Aramid-Gewebe oder Aramid-Vliesstoff, ersetzt. Die Kleberschicht durchtränkt beim Verpressen die textile Verstärkung vollständig und verklebt sie mit dem starren Einzelteil im starren Bereich. Die ausgehärtete Kleberschicht mit der textilen Verstärkung bildet gleichzeitig die flexible Isolationsfolie, wobei die textile Verstärkung eine hohe Dimensionsstabilität und Einreißfestigkeit der Isolationsfolie gewährleistet.

Es ist für den Fachmann leicht einsichtig, daß zwei oder mehrere so gestaltete, starr-flexible Laminate nach der Herstellung der Leiterbilder auf den Innenlagen übereinander gestapelt und mit Hilfe von Verbundfolien zwischen den Laminaten zu einer Mehrlagenschaltung unter Druck und Temperatur verpreßt werden können.

Die Erfindung wird im folgenden anhand von Figuren näher erläutert. Es zeigen:

Figur 1 in Draufsicht den Nutzen einer starr-flexiblen Leiterplatte nach dem Herstellen des Leiterbildes und vor dem Herstellen der Außenkontur;

Figur 2 in Draufsicht die fertige starr-flexible Leiterplatte;

Figur 3 bis 7 im Querschnitt das erfindungsgemäße Herstellungsverfahren.

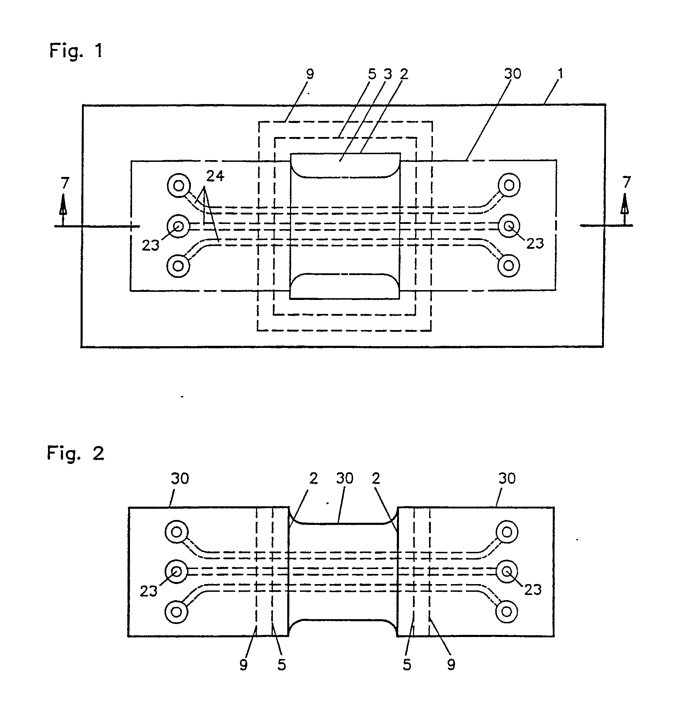

Figur 1 zeigt eine beispielhafte Ausführungsform einer starr-flexiblen Leiterplatte, deren Durchkontaktierungen 23 und Leiterbild 24 bereits nach bekannten Verfahren hergestellt sind, aber deren Kontur 26 im Nutzen noch bearbeitet werden muß, z.B. durch Fräsen oder Stanzen, um die fertige Leiterplatte, wie in Figur 2 dargestellt, zu erhalten. Nach der Konturbearbeitung kann der perforierte Teil 3 der starren Einzellage leicht herausgelöst werden.

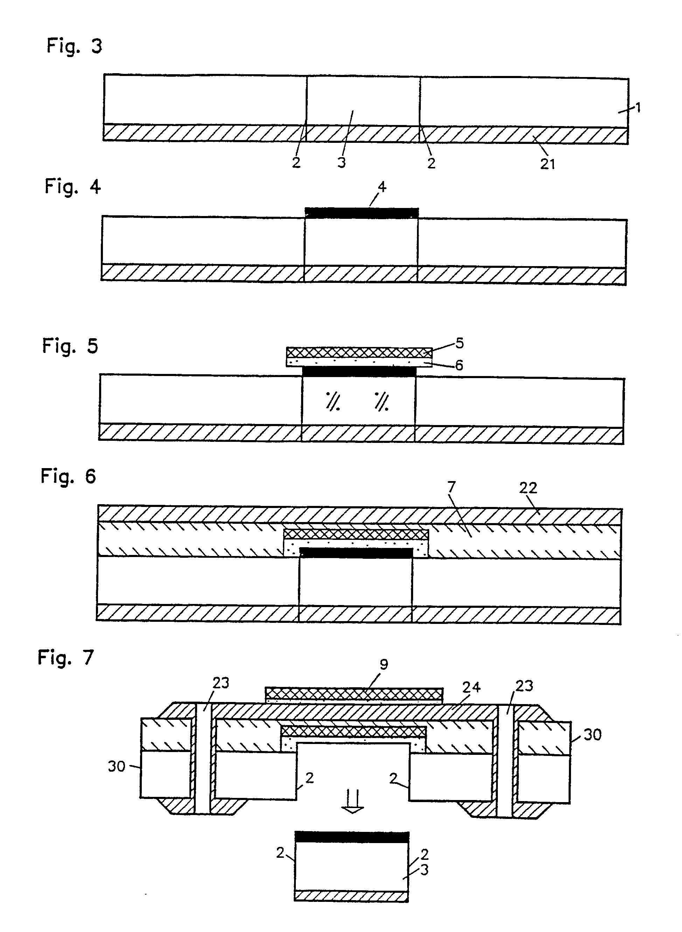

Der Lagenaufbau der Leiterplatte besteht zunächst aus einer starren Einzellage 1, deren Material ein Epoxidhartglasgewebe darstellt. Die Einzellage 1 weist einseitig eine Kupferkaschierung 21 auf, in der Sollbruchstellen 2 durch Stanzen entlang der Trennungslinie vom starren zum flexiblen Teil der Leiterplatte vorgesehen sind, die es ermöglichen, nach der Konturbearbeitung das starre Teilstück 3 über den flexiblen Bereich zu entfernen (Figur 3).

Danach wird auf dieses Teilstück 3 eine Trennschicht durch Besprühen mit PTFE-Spray hergestellt (Figur 4). Anschließend wird eine Polyimidfolie 5, die mit einer Kleberschicht 6 versehen ist, in dem flexiblen Bereich positioniert, wobei diese Polyimidfolie 5 als Basisfolie des flexiblen Bereichs der Leiterplatte dient und den flexiblen Bereich allseitig um 4 mm überragt, um eine ausreichende Haftung zwischen Folie und starrem Material zu erzielen (Figur 5).

Als nächste Lagen werden ganzflächig eine Klebefolie 7 und eine Kupferfolie 22 aufgelegt. Die Klebefolie besteht aus einem nichtausgehärteten Epoxidharz und ist etwa gleich dick wie die Basisfolie 5 bzw. 6. Wegen der besseren Handhabung ist es von Vorteil, wenn die Kupferfolie bereits mit diesem Epoxidharz beschichtet ist.

Der Verbund wird dann bei einer Temperatur von 175° C und einem Druck von 15 bar zu einem Laminat verpreßt, wobei am Anfang des Preßzyklus das Epoxidharz niedrigviskos wird, dadurch die Basisfolie 5 bzw. 6 einbettet (Figur 6) und dann aushärtet. Damit wird die Kupferfolie 22 mit der Polyimidfolie 5 und dem Epoxidhartglasgewebe 1 dauerhaft und lötbadbeständig verklebt.

Das Laminat wird anschließend durchkontaktiert, und die Leiterbilder werden strukturiert. Nach der Bearbeitung der Konturen 30 kann das Teil 3 entlang der vorgeformten Sollbruchstellen leicht entfernt werden (Figur 7), da der Kleber 6 der Basisfolie 5 im flexiblen Bereich wegen des Trennmittels 4 den Teil 3 mit der Polyimidfolie 5 nicht verklebt.

Bezugszeichenliste:

| | |
|---|---|
| 1 | starre Einzellage |
| 2 | Sollbruchstellen in der starren Einzellage |
| 3 | Teilstück der starren Einzellage |
| 4 | Trennschicht auf dem Teilstück 3 |
| 5 | Isolierfolien-Stück |
| 6 | Kleberschicht auf dem Isolierfolien-Stück 5 |
| 7 | ganzflächige Kleberschicht zwischen starrer Einzellage 1 sowie Isolierfolien-Stück 6 und Kupferfolie 22 |
| 9 | Deckfolien-Stück |
| 21 | Kupferfolie, kaschiert auf der starren Einzellage 1 |
| 22 | Kupferfolie über der Kleberschicht 7 |
| 23 | Durchkontaktierte Bohrung |
| 24 | Leiterbahnen |
| 30 | Kontur der starr-flexiblen Leiterplatte |

**Patentansprüche**

1. Verfahren zur Herstellung einer starre und flexible Bereiche aufweisenden Leiterplatte durch Verpressen von starren und flexiblen Einzellagen und Entfernen der starren Außenlage in den flexibel gewünschten Bereichen, wobei zur Entfernung der starren Außenlage in diesen Bereichen entlang den Trennlinien zwischen starren und flexiblen Teilen der Leiterplatte vor dem Verpressen nach Ausbildung der Leiterbilder Sollbruchstellen hergestellt und die Bereiche zwischen diesen herausgebrochen werden, dadurch gekennzeichnet, daß man nach dem Ausbilden der Sollbruchstellen (2) auf der starren, mit einer Kupferschicht (21) kaschierten Einzellage (1) innerhalb des flexibel zu gestaltenden Bereichs (3) ein die Klebefähigkeit des verwendeten Klebers (6) verhinderndes, bis zu 200 °C temperaturbeständiges Trennmittel (4) in flüssiger Form oder als Trennfolie auf die der Kupferschicht (21) abgewandte Seite aufträgt, daß man anschließend eine mit Kleber (6) beschichtete Isolationsfolie (5) auf die starre Einzellage (1) nur im flexibel zu gestaltenden Bereich (3) aufklebt, wobei die Isolationsfolie (5) allseitig um 3 bis 5 mm die Abmessungen des Bereichs (3) überragt,

daß man dann über die Isolationsfolie (5) einschließlich der starren Bereiche der Einzellage (1) eine durchgehende Kupferfolie (22) mittels einer klebenden Schicht (7) klebt, wobei diese Schicht (7) auf ihrer gesamten Fläche die Isolationsfolie (5) um mindestens 1 μm in der Höhe überragt,

daß man den Verbund unter Druck und Hitze zu einem Laminat verpreßt, die Klebeverbindungen aushärten läßt und,

nach der Leiterbild-Herstellung (23, 24) und der Konturbearbeitung (30),

zuletzt im flexiblen Bereich (3) die Einzellage (1) mit der Kupferbeschichtung (21) entlang den Sollbruchstellen (2) entfernt.

2. Verfahren nach Anspruch 1, dadurch gekennzeichnet, daß man als die die Kupferfolie (22) verklebende Schicht (7) ein Prepreg aus einem harzgetränkten Glasgewebe verwendet, wobei das Harz des Prepregs und das Material der Einzellage (1) miteinander in der Hitze verklebbar sind.

3. Verfahren nach Anspruch 1 oder 2, dadurch gekennzeichnet, daß man eine Isolationsfolie (5) mit einer textilen Verstärkung verwendet.

4. Verwendung einer gemäß den Ansprüchen 1 bis 3 hergestellten Leiterplatte als Vorlaminat für mehrlagige starr-flexible Leiterplatten.

Fig. 1

Fig. 2

EP 0 440 928 A2

Fig. 3

2  3  2  21  1

Fig. 4

4

Fig. 5

5
6

Fig. 6

7  22

Fig. 7

9
23  24  23
30
30
2  ⇓  2
2  2
3

6